# EUROPEAN PATENT SPECIFICATION

(11) **EP 0 399 595 B1**
(45) Date of publication and mention of the grant of the patent: **16.03.1994**
(21) Application number: 90201229.3
(22) Date of filing: 15.05.1990
(51) Int. Cl.: H02B 1/34

(54) **Sectional container for electrical boards assembled with joints**
Mittels Verbindungsteilen zusammengebauter Schrank für elektrische Installationen
Armoire pour installations électriques assemblée par liens

(30) Priority: 24.05.1989 IT 2113689 U
(43) Date of publication of application: 28.11.1990
(73) Proprietor: S.I.F.E. SOCIETA' ITALIANA FORNITURE ELETTRICHE S.p.A., Senago (Milano) (IT)
(72) Inventor: Balzanelli, Vincenzo, Milano (IT)
(74) Representative: Raimondi, Alfredo, Dott. Ing. Prof.

(56) References cited:
- DE-A- 1 554 416
- DE-A- 2 056 158
- DE-B- 2 046 435
- DE-U- 1 985 358

## Description

The subject of the present patent is a container with cabinet or the like for electrical equipment, which can be assembled by means of fixed joints.

In the art of installations for electrical control panels and the like, many forms of container cabinets are known, which however possess numerous disadvantages, among which are the need for them to be pre-assembled, thus requiring considerable storage space, or with the possibility of assembly by fixing means such as screws, bolts and the like, which require long assembly times and provide little possibility for variation and modular construction of the cabinet. There is also known, from the Patent FR - 2 556 169, a cabinet which can be assembled at the time of installation, but which possesses the serious disadvantage of having, as fixed load-bearing element to which the remainder of the structure is firmly attached, the back closure panel, which prevents access to the electrical equipment from the rear side.

A container of this type being also known by DE-15 54 416 into which a container having a plurality of profile elements couplable in a relative angular or linear position by means of coupling joints is disclosed.

The technical problem therefore arises of creating a housing cabinet for electrical equipment which shall be easy to assemble and dismantle, shall be modular so that it can be increased in volume for future installation also, and shall be composed of symmetrical, interchangeable parts 30 as to reduce the number of production dies or moulds and, consequently, the number of components to be stocked, and which shall make possible easy access to the installed electrical equipment both from the front and from the rear.

Said results are achieved by the present invention, which provides a sectional container for electrical equipment and the like, comprising a plurality of hollow boards constituting the side and end plates of the container and capable of being coupled together in relative angular or linear position by means of coupling joints, in which the internal supports for the equipment to be installed are constituted of brackets fixed to said sides and parallel to them, to which are slidably fitted angle pieces, horizontal support bars being firmly attached to the side of these angle pieces perpendicular to said cabinet side for the support of the electrical equipment to be installed, the access to this equipment being possible both from the front and from the rear.

Said hollow boards constituting cabinet side plates and end plates have a constant section and width but different lengths, to allow the extension of the total volume of the container, while keeping its depth fixed; moreover, the section of said sides and ends is asymmetrical, to allow the fitting of rear and front closure panels and a front door, without thereby exceeding the overall dimension of the sides.

It is also provided that said coupling joints are constituted of a central body of square section, from which project flanges of rectangular section for the reversible fixing into the ends of said hollow boards constituting cabinet sides and ends, the side dimension of said central body being larger than the depth of said fixing flanges in order to form a stop against the end edges of said side plates and end plates.

Said support brackets are equipped, at each end, with a central pin element for engagement with a corresponding hole formed on flanged edge of said hollow boards constituting the sides of the container, and with foldable lugs for the fixing of the brackets to said edge, the brackets being also equipped with a slot for the slidable seating of said angle piece.

Further details will be understood from the following description, given with reference to the attached drawings, in which there are shown:
- in Figure 1:: an exploded view of a cabinet, in single configuration;
- in Figure 2:: a view of an assembly detail for the elements carrying electrical equipment;
- in Figure 3:: a section on the plane III - III of Figure 2;
- in Figures 4a & 4b:: a view of horizontal and vertical connecting joints respectively;
- in Figure 5:: a view of a side panel of Figure 1;
- in Figure 6:: a view of a detail of an example of an open intermediate wall.

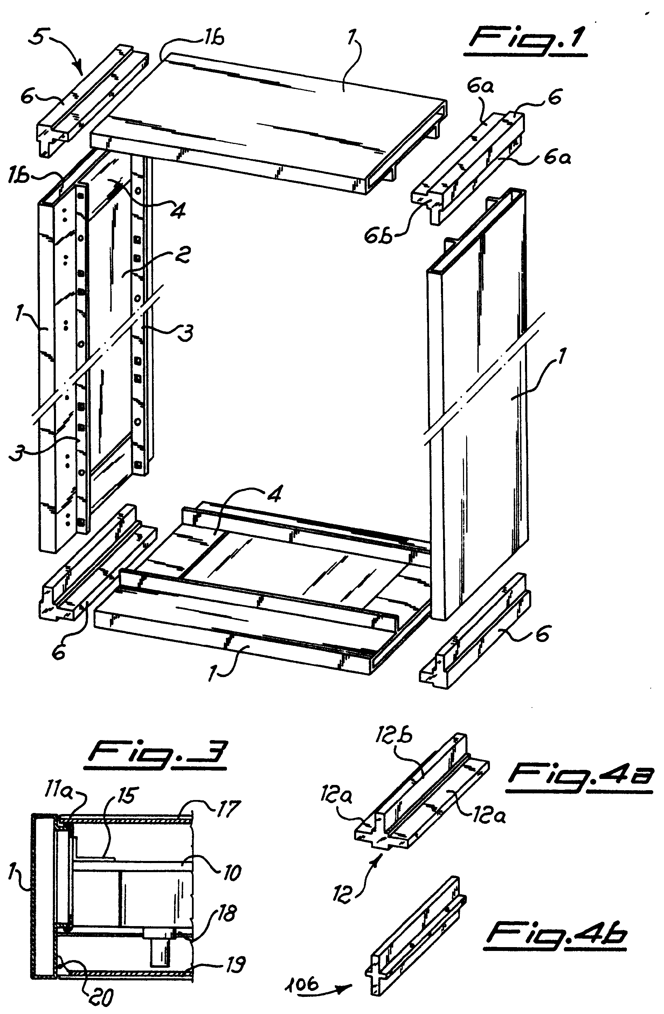

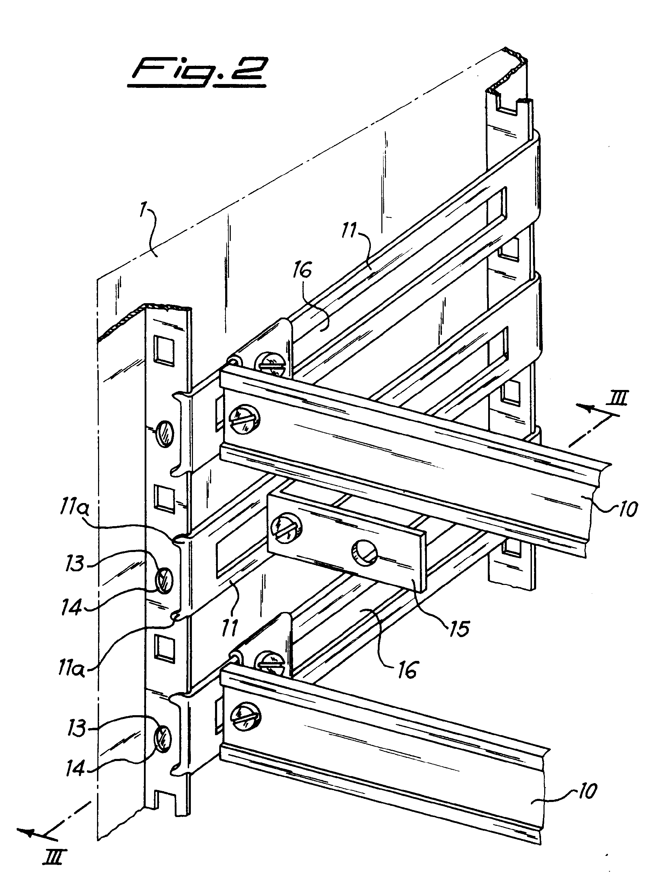

With reference to Figures 1, 3 and 5, the container for electrical equipment according to this invention is composed of hollow boards 1 of constant section and width but of different lengths, adapted for forming the sides and the ends of said container; said section having the complete shape of an asymmetric box with an opening 2 towards the inside of the container, bounded by two flanges 3 folded at 90° with respect to the profile itself and extending throughout its length.

The hollow boards 1 are completed by two further shaped elements 4, disposed at each end of the profile element 1.

As illustrated for example in Fig. 1, the coupling together between the different profile elements is effected by means of coupling joints referenced generally 5, which in the case of the side plate / top coupling of Fig. 1 will have an angular configuration 6, composed of two flanges 6a, connected at a right angle by means of a square bar 6b having a side dimension greater than the thickness of the flanges 6a; in this manner, when the coupling is effected, the two flanges 6a are forced onto the ends of the side and top elements respectively, until their edges lb come into bearing against the bar 6b, thus forming an angle coupling.

Analogously in the case of linear couplings, for the purpose of extending the container in a horizontal or vertical direction, joints 12, 106 of the type illustrated in Figures 4a and 4b respectively are used. In particular, in the case of extensions to the container in the horizontal direction, the angle 5 will be replaced by the coupling joint 12 comprising three flanges, of which two, referenced 12a, are for the support of two horizontal end boards and one, 12b, for the vertical side boards.

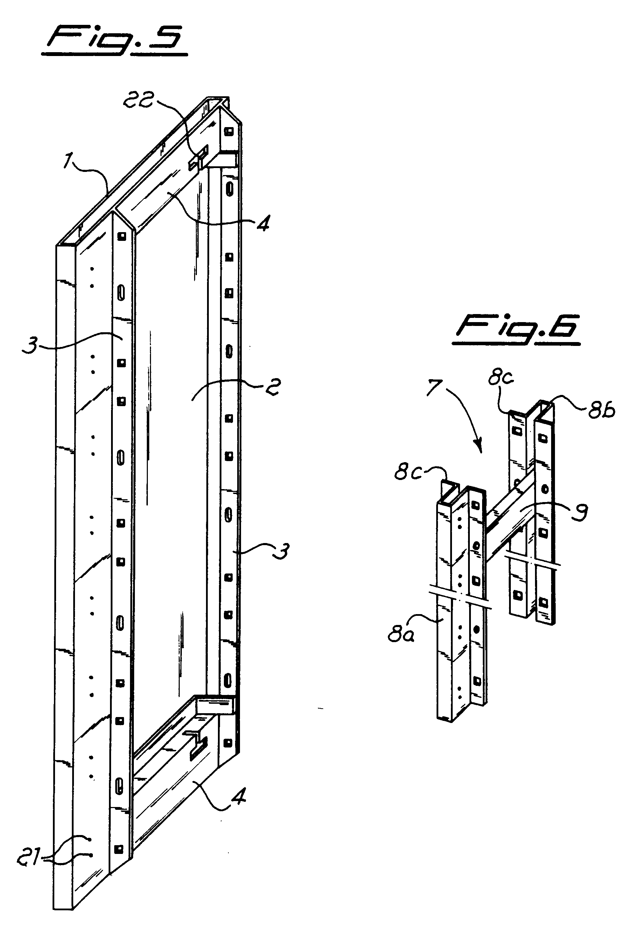

In this case, however, the boards 1 which constitutes the side plate is replaced by a different transverse member 7, illustrated in Fig. 6; said transverse member, when the extension has been completed, becomes an internal partition, which should be open to allow the passage of the cables from and to the equipment present in the container on the opposite side of said partition; it is therefore formed of two U-section uprights, respectively 8a and 8b, with bent flanges 8c for the fixing, between said uprights at different heights, of stiffening cross-members 9.

Once the external volume of the container has been constructed, it is completed by the fitting of the rear support bars 10 for the electrical equipment to be installed; this fitting is effected by means of brackets 11 (Fig. 2), which are centred by means of a pin 13 in the holes 14 of the flanges 3 of the side plates 1, and which are blocked in position by folding of end lugs lla; to said brackets there are firmly fixed angle pieces 15, slidable in a slot 16 formed on the brackets 11. In this way it is possible to fix the support elements for the electrical equipment to be installed, at various preselected heights and depths. Once the installation operations have been completed, which are facilitated by the possibility of gaining access to the container both from the front and from the back, said container is completed by the rear closure panel 17, the front closure panel 18 and the front door 19, fitted by means of hinges 20, attached by appropriate fixing means to the holes 21 formed on the side plates 1.

In a variant, it is also arranged that shaped openings 22 be formed in correspondence, on the joints 5 and on the profile elements 4, for the fitting of further means, such as for example screws or the like for fixing the joints to the elements 1.

It is furthermore provided, in the particular case of a horizontal and vertical extension, that joints having four symmetrical flanges shall be used, of obvious construction and therefore not shown here.

## Claims

1. Sectional container for electrical equipment and the like, comprising a plurality of hollow boards (1) constituting the side plates and the end plates of the container and capable of being coupled together in a relative angular or linear position by means of coupling joint (5), characterized by the internal supports for the equipment to be installed being constituted of brackets (11) firmly fixed to said side plates (1) and parallel to them, to which brackets (11) angle pieces (15) are slidably fitted, horizontal support bars (10) for the support of the electrical equipment to be installed being firmly attached to the side of said angle pieces (15) perpendicular to said side plate (1), this combination making possible access to said equipment both from the front and from the rear.

2. Sectional container for electrical equipment and the like according to Claim 1, characterized by the fact that said hollow boards (1) constituting side plates and end plates have the same section and width but different lengths to allow the extension of the total volume of the container while maintaining its depth unchanged.

3. Sectional container for electrical equipment and the like according to Claim 1, characterized by the fact that the section of said side plates (1) and end plates is asymmetrical, to permit the fitting of rear (17) and front (18) closure panels and front door (19) without exceeding the overall dimensions of the side plates.

4. Sectional container for electrical equipment and the like according to Claim 1, characterized by the fact that said coupling joints are constituted of a central body (6b) of square section, from which flanges (6a) of rectangular section extend for the reversible fixing into the ends of said hollow boards (1) constituting side plates and end plates.

5. Sectional container for electrical equipment and the like according to Claim 4, characterized by the fact that the side dimension of said central body (6b) is greater than the thickness of said flanges (6a) in order to form a stop against the end edges of said side plates and end plates.

6. Sectional container for electrical equipment and the like according to Claim 1, characterized by the fact that said joints form a linear coupling (106), a right-angled coupling (6), a "T" coupling (12) and a cruciform coupling.

7. Sectional container for electrical equipment and the like according to Claim 1, characterized by the fact that said support brackets (11) are equipped, at each end, with a central pin (13) element for engagement with a corresponding hole (14) formed on a flanged edge (3) of said hollow boards (1) constituting the side plates of the container and with lugs (112) which can be folded over for fixing the bracket (11) to said edge, (3) the bracket being also provided with a slot (16) for the slidable seating of said angle piece (15).

## Patentansprüche

1. Mehrteiliger Behälter für elektrische Ausrüstung und dergleichen, mit mehreren hohlen Platten (1), welche die Seitenplatten und die Abschlußplatten des Behälters darstellen und in einer Winkelstellung oder linearen Position zueinander durch Verbindungselemente (5) miteinander gekoppelt werden können, **dadurch gekennzeich****net,** daß die inneren Träger für die zu installierende Ausrüstung aus Schienen (11) bestehen, die mit den Platten (1) fest verbunden und parallel zu ihnen sind, wobei Winkelstücke (15) verschiebbar zu den Schienen (11) angebracht sind und horizontale Trägerglieder (10) zur Aufnahme der zu installierenden elektrischen Ausrüstung fest mit der Seite der Winkelstücke (15) verbunden sind, die senkrecht zu der Seitenplatte (1) ist, so daß durch diese Kombination die Ausrüstung sowohl von vorne als auch von hinten zugänglich ist.

2. Mehrteiliger Behälter für elektrische Ausrüstung und dergleichen nach Anspruch 1, **dadurch gekennzeichnet,** daß die hohlen Platten (1), welche Seitenplatten und Abschlußplatten bilden, denselben Durchmesser und dieselbe Breite, aber unterschiedliche Längen haben, um die Vergrößerung des Gesamtvolumens des Behälters zu ermöglichen, während seine Tiefe unverändert bleibt.

3. Mehrteiliger Behälter für elektrische Ausrüstung und dergleichen nach Anspruch 1, **dadurch gekennzeichnet**, daß der Querschnitt der Seitenplatten (1) und Abschlußplatten asymmetrisch ist, um die Anbringung von hinteren (17) und vorderen (18) Abschlußwänden und einer Vordertür (19) zu ermöglichen, ohne daß die Gesamtabmessungen der Seitenplatten überschritten werden.

4. Mehrteiliger Behälter für elektrische Ausrüstung und dergleichen nach Anspruch 1, **dadurch gekennzeichnet**, daß die Verbindungselemente aus einem Zentralkörper (6b) von quadratischem Querschnitt gebildet sind, von dem Flansche (6a) von rechteckigem Querschnitt ausgehen zur lösbaren Befestigung in den Enden der hohlen Platten (1), welche die Seitenplatten und die Abschlußplatten bilden.

5. Mehrteiliger Behälter für elektrische Ausrüstung und dergleichen nach Anspruch 4, **dadurch gekennzeichnet**, daß die Seitenabmessungen des Zentralkörpers (6b) größer sind als die Dicke der Flansche (6a), um einen Anschlag gegen die Endränder der Seitenplatten und der Abschlußplatten zu bilden.

6. Mehrteiliger Behälter für elektrische Ausrüstung und dergleichen nach Anspruch 1, **dadurch gekennzeichnet**, daß die Verbindungselemente eine lineare Verbindung (106), eine rechtwinklige Verbindung (6), eine "T"-Verbindung (12) und eine kreuzförmige Verbindung bilden.

7. Mehrteiliger Behälter für elektrische Ausrüstung und dergleichen nach Anspruch 1, **dadurch gekennzeichnet,** daß die Trägerschienen (11) an jedem Ende mit einem zentralen Stiftelement (13) zum Eingriff in ein entsprechendes Loch (14) ausgestattet sind, das an einem Flanschrand (3) der hohlen Platten (1), welche die Seitenplatten des Behälters bilden, angebracht ist, und mit Nasen (11a), die umgeschlagen werden können, um die Schiene (11) an dem Rand (3) zu befestigen, wobei die Schiene auch mit einem Schlitz (16) versehen ist, in dem ein Winkelstuck (15) verschiebbar befestigt ist.

## Revendications

1. Armoire démontable pour équipements électriques et analogues, comprenant un ensemble de panneaux creux (1) constituant les plaques latérales et les plaques d'extrémité de l'armoire et pouvant être couplées entre elles dans une position angulaire ou linéaire relative au moyen d'éléments de liaison par couplage (5), caractérisée par le fait que les supports internes pour les équipements à mettre en place sont constitués de consoles (11) reliées fermement auxdites plaques latérales (1) et parallèles à ces dernières, des équerres (15) étant montées à coulissement sur ces consoles (11), des barres de support horizontales (10) pour le support des équipements électriques à mettre en place étant reliées fermement au côté desdites équerres (15) perpendiculairement à ladite plaque latérale (1), cette combinaison rendant possible un accès auxdits équipements à la fois depuis l'avant et depuis l'arrière.

2. Armoire démontable pour équipements électriques et analogues selon la revendication 1, caractérisée par le fait que lesdits panneaux creux (1) constituant les plaques latérales et les plaques d'extrémité présentent la même section et la même largeur mais des longueurs différentes afin de permettre l'extension du volume total de l'armoire tout en maintenant inchangée sa profondeur.

3. Armoire démontable pour équipements électriques et analogues selon la revendication 1, caractérisée par le fait que la section desdites plaques latérales (1) et desdits plaques d'extrémité est asymétrique afin de permettre le montage de plateaux de fermeture arrière (17) et avant (18) et d'une porte frontale (19) sans dépasser les dimensions totales des plaques latérales.

4. Armoire démontable pour équipements électriques et analogues selon la revendication 1, caractérisée par le fait que lesdits éléments de liaison par couplage sont constitués par un corps central (6b) de section carrée à partir duquel s'étendent des ailes (6a) de section rectangulaire pour la fixation réversible dans les extrémités desdits panneaux creux constituant les plaques latérales et les plaques d'extrémité.

5. Armoire démontable pour équipements électriques et analogues selon la revendication 4, caractérisée par le fait que la dimension latérale dudit corps central (6b) est supérieure à l'épaisseur desdites ailes (6a) afin de former une butée contre les bords d'extrémité desdites plaques latérales et desdites plaques d'extrémité.

6. Armoire démontable pour équipements électriques et analogues selon la revendication 1, caractérisée par le fait que lesdits éléments de liaison forment un couplage linéaire (106), un couplage à angle droit (6), un couplage en "T" (12) et un couplage cruciforme.

7. Armoire démontable pour équipements électriques et analogues selon la revendication 1, caractérisée par le fait que lesdites consoles de support (11) sont équipées, à chaque extrémité, d'un élément à tige centrale (13) pour rentrer dans un trou correspondant (14) formé sur un bord (3) présentant une aile desdits panneaux creux (1) constituant les plaques latérales de l'armoire, et de pattes (112) qui peuvent être repliées pour la fixation de la console (11) audit bord (3), la console étant également munie d'une fente (16) pour faire reposer ladite équerre (15) en lui permettant de coulisser.
